# EUROPÄISCHE PATENTSCHRIFT

(11) **EP 3 234 992 B1**
(45) Veröffentlichungstag und Bekanntmachung des Hinweises auf die Patenterteilung: **26.09.2018**
(21) Anmeldenummer: 17706956.4
(22) Anmeldetag: 23.01.2017
(51) Int. Cl.: H01L 21/683, H01L 21/67, H05K 13/04, H01L 23/00, H01L 21/677

(54) **VERFAHREN UND VORRICHTUNG ZUM HERAUSLÖSEN EINES MIKRO-CHIPS AUS EINEM WAFER UND AUFBRINGEN DES MIKRO-CHIPS AUF EIN SUBSTRAT**
METHOD AND APPARTUS FOR DETACHING A MICRO-CHIP FROM A WAFER AND PLACEMENT OF THE MICRO-CHIP ON A SUBSTRATE
MÉTHODE ET APPAREIL POUR DÉTACHER UNE MICRO-PUCE D'UNE PLAQUETTE ET PLACEMENT DE LA MICRO-PUCE SUR UN SUBSTRAT

(30) Priorität: 29.01.2016 DE 102016001322
(43) Veröffentlichungstag der Anmeldung: 25.10.2017
(73) Patentinhaber: JENOPTIK Optical Systems GmbH, 07745 Jena (DE)
(72) Erfinder: PANITZ, Meik, 99423 Weimar (DE)
(74) Vertreter: Schaller, Renate
(86) Internationale Anmeldenummer: PCT/DE2017/100035
(87) Internationale Veröffentlichungsnummer: WO 2017/129171

(56) Entgegenhaltungen:
- EP-A1- 2 852 271
- JP-A- 2005 322 815
- US-A1- 2004 118 515
- US-A1- 2007 069 340
- US-A1- 2010 143 088

## Beschreibung

Im Zuge der fortschreitenden Komplexität von immer mehr Baugruppen und/oder Bauteilen in immer kleiner werdende Einheiten z.B. in der Halbleiter- und Mikrosystemtechnik, der Telekommunikation, der Sicherheitstechnik, der Energieerzeugung oder der Messtechnik, werden die Baugruppen und/oder Bauteile zunehmend mehr durch einzelne Chips vergegenständlicht, die nebeneinander auf einem Substrat aufgebracht werden.

Derartige Chips können Außenabmessungen aufweisen, die im µm Bereich liegen.

Als ein Substrat im Sinne dieser Beschreibung wird ein Grundmaterial verstanden, dass als Träger für z.B. Platinen, Schaltkreise, Leiterplatten, Lithografie- oder Photomasken, Baueinheiten z.B. für Smartphones, im Mobilfunk oder für chipbasierte Lösungen für die Sicherheit, wie z.B. Reisepässe, für SIM-Cards, für energieeffiziente Lösungen, für Speichereinheiten usw. dient. Es kann aber auch eine Platine sein, die bereits in einer erforderlichen Form vorbehandelt oder einseitig behandelt oder ausgestattet ist.

Für die Bestückung eines Substrates mit Chips werden typischerweise klassische Pick- and Place-Roboter eingesetzt. Diese verarbeiten typischerweise Komponenten bzw. Chips, die eine Dicke von mehreren 100 µm und eine Fläche von einigen mm² bis über einem cm² aufweisen. Sie sind nicht geeignet, um Mikro-Chips, das heißt im Sinne dieser Anmeldung Chips mit einer Fläche von höchstens wenigen mm² Fläche, insbesondere einer Fläche von kleiner 1 mm² und Dicken unter 200 µm bis unter 50 µm, z.B. 5 µm, zu handeln. Mikro-Chips mit einer Fläche von unter einem mm² und einer Dicke kleiner 5 µm werden nachfolgend, sofern eine Aussage beschränkt auf Mikro-Chips in dieser Größenordnung getroffen wird, als Membran-Chip bezeichnet. Neben den typischen Mikro-Chips mit elektronischer Funktion, nachfolgend elektronische Mikro-Chips, gibt es Mikro-Chips mit optischer Funktion, nachfolgend optische Mikro-Chips. Sie können im Vergleich zu den elektronischen Mikro-Chips noch kleinere Abmessungen aufweisen, insbesondere kleinere Dicke, die nur 1 - 2 µm betragen. Auch die Flächengröße, bestimmt durch Länge und Breite von ca. 30 µm bis 1 mm kann noch kleiner sein als die elektronischer Mikro-Chips. Optische Mikro-Chips werden aus optisch transparenten Materialien z. B. SiO2 oder Si3N4 hergestellt. Insbesondere optische Mikro-Chips werden daher als Membran-Chips ausgeführt.

Es ergeben sich für Mikro-Chips und insbesondere Membran-Chips Dimensionen von bis zu zwei Größenordnungen unter denen von klassischen Chips und damit Massen, welche um etwa sechs Größenordnungen geringer sind. Aus der geringen Dicke und der kleinen Fläche resultieren spezifische Probleme bezüglich des Handlings, der genauen Positionierung, der Ebenheit, der stabilen Verbindung und gegebenenfalls der leitfähigen Kontaktierung der Mikro-Chips.

Durch herkömmliche Bestückungsautomaten, Klebe/Lotverbindungen, Draht- oder Flip-Chip Kontaktierung können Mikro-Chips, mit derartig kleinen geometrischen Abmessungen nicht verarbeitet werden. Es kann nur eingeschränkt oder nicht auf die klassische AVT (Aufbau- und Verbindungstechnik-) -Verfahren zurückgegriffen werden, wie Sägen, Pick and Place, Kleben, Löten, Draht- oder Flip Chip Bonden.

Zum Beispiel gibt es zwar für die Probenmanipulation von Focused Ion Beam (FIB)-Schnitten Mikromanipulatoren, diese sind jedoch sehr teuer in der Anwendung und nicht für eine schnelle und effiziente Bauteilfertigung bzw. Mikro-Chip-Verarbeitung geeignet. Ebenso sind viele mikromechanische Greifer in der Literatur dokumentiert, diese erlauben jedoch keinen langen Verfahrweg und müssten umständlich mit langen Manipulatoren hoher Reichweite kombiniert werden.

Die EP 1 336 986 A1 offenbart ein Verfahren zur Herstellung eines Wafers mit wenigstens einem dünnen elektronischen Mikro-Chip, der in einem Trägerkörper durch eine Vielzahl den Trägerkörper und den Mikro-Chip verbindende Haltelaschen (dort Befestigungsmechanismen) gehalten wird, sowie eine Vorrichtung und ein Verfahren zum Herauslösen eines solchen elektronischen Mikro-Chips aus einem Wafer und Handling des herausgelösten Mikro-Chips. Als Mikro-Chip werden hier Chips verstanden mit einer Dicke geringer 100 µm, insbesondere mit einer Dicke zwischen 50 µm und 5 µm.

Ein vorgefertigter Wafer mit Mikro-Chips, die jeweils innerhalb einer Aussparung eines Trägerkörpers durch eine Vielzahl den Trägerkörper und den Mikro-Chip verbindende Haltelaschen gehalten werden, hat den Vorteil, dass die Mikro-Chips fertig sind, um nach dem Herauslösen transportiert und auf einem Substrat aufgebracht zu werden, ohne dass sie einem weiteren Bearbeitungsprozess unterzogen werden müssen.

Zum Schutz des Wafers während des Transportes und des Handlings sowie zur Entnahme der Mikro-Chips wird der Wafer auf einer Unterlage platziert, die eine Anordnung von Durchgangslöchern, korrelierend zu den Aussparungen des Trägerkörpers aufweist, so dass die Durchgangslöcher unterhalb der herauszulösenden Mikro-Chips angeordnet sind. Es ist als wichtig angegeben, dass die Unterlage steif ist, da der Wafer durch die Vielzahl von Mikro-Chips, die umschlossen von einer Rille mit dem Wafer nur über die Haltelaschen verbunden sind, bruchgefährdet ist. Durch die Durchgangslöcher hindurch ist jeweils eine freie Bewegung eines der Auswurfbolzen in einer der Aussparungen des Trägerkörpers und damit dessen Platzierung unterhalb eines der Mikro-Chips möglich.

Zum Herauslösen jeweils eines Mikro-Chips wird von der der Unterlage abgewandten Seite des Wafers her ein Handlinggerät dem Mikro-Chip zugestellt. Mit diesem Handlinggerät wird auf den Mikro-Chip ein Druck nach unten entgegen den Auswurfbolzen bewirkt. Dabei werden die Haltelaschen auf Biegung beansprucht und gebrochen. Bevorzugt wird während dessen der Mikro-Chip angesaugt, wodurch er während des Brechens der Haltelaschen nicht verrutschen kann und horizontal gehalten wird.

Nach dem Herauslösen des Mikro-Chips werden der Auswurfbolzen und das Handlinggerät gemeinsam nach oben bewegt, um sicher zu stellen, dass Reste von Haltelaschen den Mikro-Chip nicht von dem Handlinggerät abstreifen. Anschließend wird der Auswurfbolzen wieder abgesenkt und der Mikro-Chip wird an dem Handlinggerät durch ein Vakuum angesaugt gehalten und transportiert.

Um den Mikro-Chip auf einem Substrat, hier einer Membran zu platzieren, wird das Handlinggerät über der Membran positioniert und abgesenkt. Die an dem Handlinggerät vorhandene Ansaugspitze ist federgelagert, sodass sie weich aufgesetzt werden kann und die Membran nicht verletzt wird. Die Vakuumquelle wird abgeschalten und das Handlinggerät wird abgehoben und steht für die Entnahme eines nächsten Mikro-Chips zur Verfügung.

Wie der Mikro-Chip auf der Membran befestigt wird ist nicht angegeben.

Als Umfangsform der Mikro-Chips gemäß der vorgenannten EP 1 336 986 B1 lässt sich die Rechteckform ableiten, das heißt die Umfangskante des Mikro-Chips wird durch ein Rechteck bildende Geraden beschrieben.

Im Unterschied zur vorgenannten EP 1 336 986 B1 bei der die Umfangskante durch einen den elektronischen Mikro-Chip vollständig umschließenden Schlitz begrenzt wird, der durch nachträglich aufgebrachte Haltelaschen teilweise überdeckt wird, ist auch die Herstellung von Mikro-Chips bekannt, die in einem Trägerkörper durch an diesem mit dem Mikro-Chip monolithisch verbundene Haltelaschen gehalten werden, die durch Stege gebildet sind, die den umschließenden Schlitz unterbrechen. Ein hierzu geeignetes Verfahren zur Herstellung von Mikro-Chips mit optischer Funktion ist z.B. das anisotrope Si-Ätzen bei dem SiO₂-Schichten zu Membranen verarbeitet werden. Aus dem Wafer, wird dann aus der ausgearbeiteten Membran durch ein Trennverfahren der Mikro-Chip entlang seiner Umfangskante bis auf verbleibende Haltelaschen in Form von Stegen herausgetrennt. Das heißt der Teil der Membran, der den Mikro-Chip bildet, bleibt mit einem Teil der Membran am Wafer, monolithisch verbunden. Auf diesem Wege konnten Mikro-Chips bislang allerdings nur begrenzt auf Dicken größer 5µm hergestellt werden, da die Verfahren zum Herauslösen für keine geringeren Dicken geeignet waren.

Die Dokumente US2004/118515-A1 und US2010/143088-A1 offenbaren ebenfalls Verfahren und Vorrichtungen zur Handhabung und zum Transfer von Halbleiterchips.

Es ist die Aufgabe der Erfindung eine Vorrichtung zu finden, die mit weniger technischem Aufwand herstellbar und insbesondere für das Handling von Membran-Chips mit einer Dicke kleiner 5 µm geeignet ist.

Es ist auch die Aufgabe der Erfindung ein Verfahren zu finden, zu dessen Durchführung es einen vergleichsweise geringeren Aufwandes bedarf und das insbesondere zum Handling eines Membran-Chips mit einer Dicke kleiner 5 µm geeignet ist.

Die Aufgabe für ein Verfahren wird gemäß Anspruch 1 und für eine Vorrichtung gemäß Anspruch 5 gelöst. Vorteilhafte Ausführungen sind jeweils in den rückbezogenen Unteransprüchen offenbart.

Die Erfindung wird nachfolgend anhand eines Ausführungsbeispieles mit Hilfe von Zeichnungen näher erläutert. Hierfür zeigen:
Fig.1 eine schematische Darstellung eines Wafers mit einem Mikro-Chip,
Fig.2 einen zur Vorrichtung positionierten Wafer und
Fig. 3a -3g Darstellungen zur Erläuterung des Verfahrensablaufes.

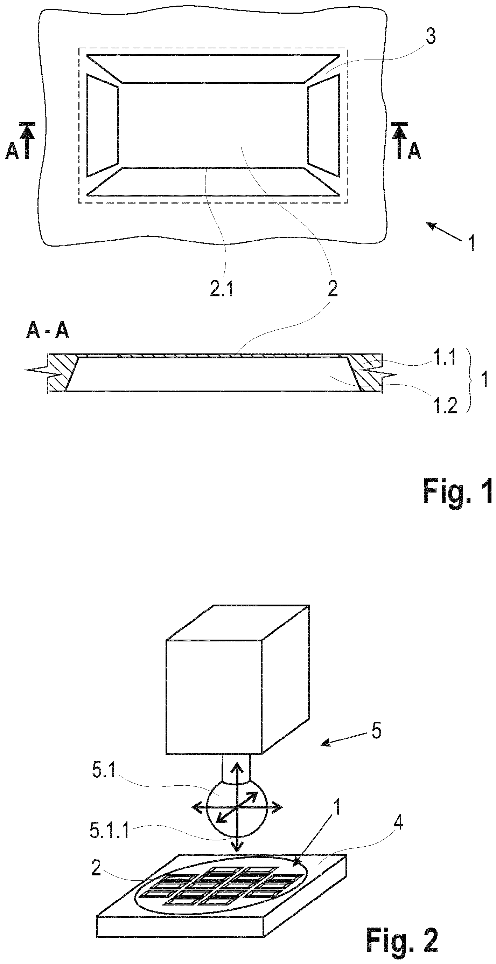

Die Vorrichtung dient dem Herauslösen von Mikro-Chips 2, insbesondere mit den Dimensionen eines Membran-Chips, aus einem Wafer 1, wobei der Wafer 1 von einem Trägerkörper 1.1 gebildet wird, mit Aussparungen 1.2 in denen über Haltelaschen 3 jeweils einer der Mikro-Chips 2 gehalten wird. Ein derartiger Wafer 1 ist schematisch in Fig. 1 gezeigt. Die Mikro-Chips 2 weisen jeweils sehr kleine Abmessungen, z.B. 3 µm x 100 µm x 250 µm, und damit insbesondere eine sehr geringe Dicke auf. Üblicherweise beschreibt die Umfangskante 2.1 des Mikro-Chips 2 als gebräuchlichste Form ein Rechteck. Andere Umfangsformen wie Kreise oder Dreiecke sind denkbar, wobei es für ein erfindungsgemäßes Verfahren von Vorteil ist, wenn die Haltelaschen 3 in einem gleichen Abstand zum Mittelpunkt des Mikro-Chips 2 an diesem angreifen und gleichmäßig um die Umfangskante 2.1 verteilt, bevorzugt an gegebenenfalls durch die Umfangskante 2.1 gebildeten Ecken angeordnet sind. Die Haltelaschen 3 können mit dem Trägerkörper 1.1 und dem Mikro-Chip 2 monolithisch verbundene Verbindungsstege darstellen. Sie können auch diskrete Elemente sein, die bevorzugt über eine stoffschlüssige Verbindung zum einen mit dem Trägerkörper 1.1 und zum anderen mit dem Mikro-Chip 2 verbunden sind. Bevorzugt weisen die Haltelaschen 3 Sollbruchstellen auf.

Zur Vorrichtung gehören grundsätzlich, wie in Fig. 2 gezeigt, eine Unterlage 4 zum Auflegen des Wafers 1 und ein Handlinggerät 5 mit einer Spitze 5.1, die horizontal zum Mikro-Chip 2 positionierbar und vertikal absenk- und anhebbar ist.

Die Spitze 5.1 weist an einem freien Ende 5.1.1 wenigstens über eine Kontaktfläche, mit der die Oberfläche der Spitze 5.1 an dem Mikro-Chip 2 zur Anlage kommt, eine Oberflächenqualität auf, die dazu ausgelegt ist, zwischen dem Mikro-Chip 2 und der Spitze 5.1 eine Adhäsionskraft zu bewirken, die nur unwesentlich größer als die Gewichtskraft des Mikro-Chips 2 ist.

Da die Adhäsionskraft zwischen der Kontaktfläche an der Spitze 5.1 und dem Mikro-Chip 2 von der Oberflächenqualität der Kontaktfläche und der Oberflächenqualität des Mikro-Chips 2 bestimmt wird, können beide aufeinander abgestimmt gefertigt werden, um eine entsprechende Adhäsionskraft in der zwischen den beiden gebildeten Grenzfläche zu erzeugen. Das heißt auch die Oberflächenqualität des Mikro-Chips 2 kann, soweit dadurch seine Funktion nicht beeinträchtigt wird, über seine Oberflächenrauheit oder Oberflächenstruktur angepasst werden.

Vorteilhaft ist das freie Ende 5.1.1 der Spitze 5.1 wenigstens im Bereich der Kontaktfläche kugelförmig ausgebildet, sodass sich der Mikro-Chip 2 beginnend von seinem Mittelpunkt MP her gleichmäßig an die Spitze 5.1 anlegt, während diese auf den Mikro-Chip 2 abgesenkt wird.

Bevorzugt ist das freie Ende 5.1.1 der Spitze 5.1 als eine Kugel, z.B. aus Rubin, aus Saphir oder einem ähnlichen Material, für das eine sehr hohe Oberflächenqualität erreichbar ist, ausgebildet.

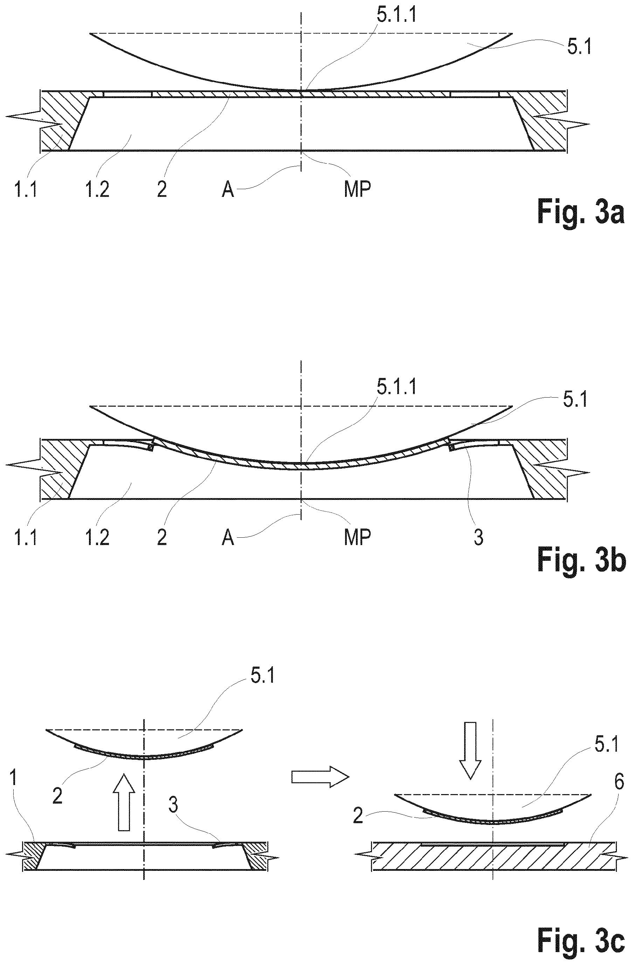

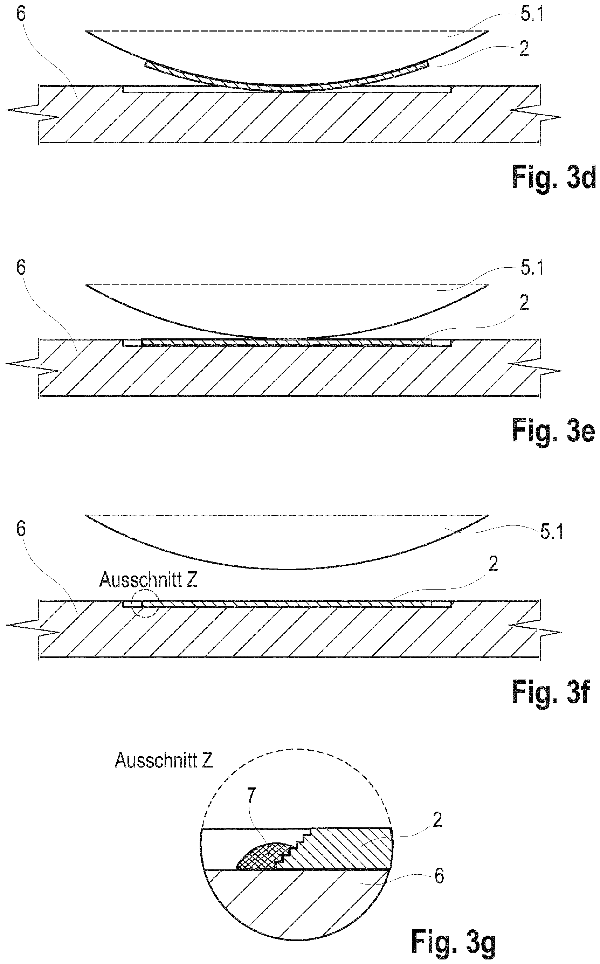

Das Herauslösen eines Mikro-Chips 2 aus einem Wafer 1 (siehe Fig. 3a) verlangt ein hochgenaues Positionieren der Spitze 5.1 oberhalb des Mikro-Chips 2. Zum einen, um den Mikro-Chip 2 definiert der Spitze 5.1 zuzuordnen und den Mikro-Chip 2 ebenso definiert auf einem Substrat 6 wieder absetzen zu können, und zum anderen, um in die Haltelaschen 3 definiert Scher- bzw. Biegekräfte einzubringen. Derartig geforderte Positioniergenauigkeiten können mit Koordinatenmessgeräten erreicht werden. Sie werden grundsätzlich zur Vermessung geometrischer Größen von Objekten verwendet, wobei berührende Sensoren (taktile) und nicht berührende Sensoren zum Einsatz kommen können.

Für eine hochgenaue Positionierung des Mikro-Chips 2 auf dem Substrat 6 ist es wichtig, das der Mikro-Chip 2 während des Handlings, das heißt beginnend mit dem ersten Kontakt mit der Spitze 5.1 bis hin zum Lösen von der Spitze 5.1 immer eine definierte Relativlage zur Spitze 5.1 hat. Das heißt die Relativlage des Mittelpunkts MP des Mikro-Chips 2 zur Mittelachse A der Spitze 5.1 und die Drehlage des Mikro-Chips 2 an der Spitze 5.1, muss unverändert erhalten bleiben. Der kritische Moment liegt hier beim Herauslösen des Mikro-Chips 2 aus dem Trägerkörper 1.1. Durch die Anordnung der Haltelaschen 3 und das definierte Aufsetzen der Spitze 5.1 auf den Mikro-Chip 2 sollen auf die Haltelaschen 3 gleiche Scher- und Biegekräfte wirken, sodass die Haltelaschen 3 zeitgleich brechen. Kommt es nicht zu einem exakt zeitgleichen Bruch der Haltelaschen 3 kann es zu dazu führen, dass der letztendlich herausgelöste Mikro-Chip 2 gegenüber seiner ursprünglichen Relativlage zur Spitze 5.1 verschoben und verdreht an dieser haftet.

Um hier abzuhelfen ist vorteilhaft bei der Herstellung eines Mikro-Chips 2, der vor dem Heraustrennen aus dem Wafer 1 über monolithische Haltelaschen 3 mit dem Trägerkörper 1.1 des Wafers 1 verbunden ist, die Umfangskante 2.1 des Mikro-Chips 2 wenigstens teilweise so ausgeführt, dass der Mirko-Chip 2 und der Trägerkörper 1.1 miteinander verzahnt angeordnet sind. Geht man davon aus, dass die Umfangskante 2.1 durch die Haltelaschen 3 in mehrere Umfangskantenabschnitte unterteilt ist, dann ist vorteilhaft an jedem der Umfangskantenabschnitt jeweils wenigstens eine Ausstülpung, die in den Wafer 1, bzw. den Trägerkörper 1.1 eingreift oder eine Einbuchtung, in die der Wafer 1 bzw. der Trägerkörper 1.1 eingreift, vorhanden. Eine Verschiebung des Mikro-Chips innerhalb einer vom Wafer aufgespannten Ebene ist dann auf den Abstand der Ausstülpung oder der Einbuchtung begrenzt. Eine Verdrehung ist auf einen Drehwinkel begrenzt, der durch ein Bogenmaß bestimmt ist, das annähernd diesem Abstand entspricht.

Neben der Verwendung einer Spitze 5.1, an der der Mikro-Chip 2 über Adhäsionskraft gehalten wird, besteht eine wesentliche Idee der Erfindung darin, ein Koordinatenmessgerät als Vorrichtung zu verwenden. Dabei stellt die Positioniereinrichtung des Koordinatenmessgerätes das Handlinggerät 5 dar und der Messtisch die Unterlage 4, wobei an der Positioniereinrichtung ein taktiler Messkopf vorhanden ist, der die Spitze 5.1 enthält.

Koordinatenmessgeräte haben gemeinsam, dass der Messkopf horizontal in y-x-Richtung eines kartesischen Koordinatensystems relativ zum Messtisch verfahrbar ist. Zumindest bei Koordinatenmessgeräten mit einem taktilen Messkopf ist dieser auch vertikal relativ zum Messtisch verstellbar. Es wird vorgeschlagen, ein solches Koordinatenmessgerät artfremd zu verwenden, um damit den Mikro-Chip 2 aus dem Wafer 1 herauszulösen, zu dem Substrat 6 zu transportieren, das zeitgleich mit dem Wafer 1 auf dem Messtisch platziert ist, und dort abzusetzen.

Der Ablauf des erfindungsgemäßen Verfahrens wird nachfolgend anhand der Fig. 3a - 3g erläutert. Zur Durchführung des Verfahrens wird ein Wafer 1, der innerhalb einer Aussparung 1.2 eines Trägerkörpers 1.1 durch eine Vielzahl von Haltelaschen 3 mit einem Trägerkörper 1.1 verbunden ist, auf einer horizontal ausgerichteten starren Unterlage 4 angeordnet.

Anschließend wird eine Spitze 5.1 eines Handlinggerätes 5, die vorteilhaft eine kugelförmige Oberfläche aufweist, oberhalb des Mikro-Chips 2, horizontal hochgenau positioniert, sodass die Mittelachse A der Spitze 5.1, durch die die Position der Spitze 5.1 definiert ist, auf den geometrischen Mittelpunkt MP des Mikro-Chips 2 auftrifft, wenn die Spitze 5.1 vertikal abgesenkt wird (Fig. 3a).

Bei einem weiteren Absenken der Spitze 5.1 taucht diese in die Aussparung 1.2 ein, während die Spitze 5.1 sich an den Mikro-Chip 2 anlegt und die Haltelaschen 3 mit Scher- und/oder Biegekräften beaufschlagt werden, bis diese brechen, sodass der Mikro-Chip 2 von dem Trägerkörper 1.1. getrennt wird (Fig. 3b).

Während des Anlegens der Spitze 5.1 an den Mikro-Chip 2 wird ein Ansprengprozess initiiert, sodass der vom Trägerkörper 1.1 getrennte Mikro-Chip 2 an der Spitze 5.1 durch Adhäsionskraft gehalten wird.

Der Mikro-Chip 2 wird anschließend mittels des Handlinggerätes 5 an der Spitze 5.1 gehalten zum Substrat 6 transportiert und dort abgelegt. Dabei wird die Spitze 5.1 vertikal angehoben, horizontal verfahren und versetzt an einem Ort oberhalb des Substrates 6 positioniert, wo der Mikro-Chip 2 vertikal abgesenkt und auf dem Substrat 6 abgelegt wird (Fig. 3c+3d). Beim Ablegen wird der Mikro-Chip 2 an dem Substrat 6 angelegt, wobei vorteilhaft ein weiterer Ansprengprozess initiiert wird. Die dabei bewirkte Adhäsionskraft zwischen dem Substrat 6 und dem Mikro-Chip 2 ist größer als die Adhäsionskraft zwischen der Spitze 5.1 und dem Mikro-Chip 2, sodass nach dem Abheben der Spitze 5.1 von dem Substrat 6 der Mikro-Chip 2 durch Adhäsionskraft an dem Substrat 6 haftet. (Fig.3e + 3f)

Das temporäre Ansprengen an der Spitze 5.1 sowie das dauerhafte Ansprengen an Substrat 6, können durch elektrostatische Kräfte, durch Anlegen von elektrischen Spannungen unterstützt werden.

Vorteilhaft kann die Spitze 5.1 auf dem Weg zum Substrat 6 oberhalb eines Mikroskops positioniert werden um z.B. den Mikro-Chip 2 auf Kontamination zu inspizieren oder die genaue Position an der Spitze 5.1 zu verifizieren.

Insbesondere wenn es sich bei den Mikro-Chips um Membran-Chips handelt kann bei einer ausreichend glatten Oberfläche des Substrats 6 auf Klebstoff als Verbindungsmittel teilweise oder ganz verzichtet werden.

Das Fixieren des Mikro-Chips 2 an dem Substrat 6 unmittelbar ohne einen Klebstoff macht die entstehende Verbindung insbesondere für Anwendungen im UV-Bereich geeignet. Um eine gesicherte dauerhafte Verbindung zu schaffen, kann vorteilhaft eine laserinduzierte Metallabscheidung, z.B. Cr Mo generiert werden, die an einem Rand des auf dem Substrat 6 haftenden Mikro-Chips 2 einen Metallwulst 7 bildet, womit der Mikro-Chip 2 dauerhaft mit dem Substrat 6 verbunden wird. Mit dieser laserinduzierten Metallabscheidung können bei Bedarf auch elektrische Kontakte zwischen dem Mikro-Chip und dem Substrat hergestellt werden.

Das erfindungsgemäße Verfahren ist insbesondere zum Heraustrennen von Membran-Chips aus einem Wafer geeignet, die in diesen winzigen Dimensionen bisher nicht hergestellt werden konnten, da es kein geeignetes Verfahren zum Herauslösen und Handeln von Mikro-Chips in dieser Größe gab.

### Bezugszeichenliste

- 1: Wafer
- 1.1: Trägerkörper
- 1.2: Aussparung
- 2: Mikro-Chip
- 2.1: Umfangskante
- 3: Haltelasche
- 4: Unterlage
- 5: Handlinggerät
- 5.1: Spitze
- 5.1.1: freies Ende
- 6: Substrat
- 7: Metallwulst
- A: Mittelachse
- MP: Mittelpunkt

## Patentansprüche

1. Verfahren zum Abtrennen eines Mikro-Chips (2) aus einem Trägerkörper (1.1) eines Wafers (1) und Aufbringen des Mikro-Chips (2) auf ein Substrat (6), wobei der Mikro-Chip (2) innerhalb einer Aussparung (1.2) des Trägerkörpers (1.1) durch eine Vielzahl von Haltelaschen (3) mit dem Trägerkörper (1.1) verbunden ist, mit folgenden Verfahrensschritten:
• Anordnen des Wafers (1) auf einer starren Unterlage (4),
• Anordnen einer Spitze (5.1) eines Handlinggerätes (5) oberhalb des Mikro-Chips (2),
• Bewegen der Spitze (5.1) abwärts hin zu dem Mikro-Chip (2), wobei während des Anlegens der Spitze (5.1) an den Mikro-Chip (2) Scher- und/oder Biegekräfte auf die Haltelaschen (3) wirken und diese gebrochen werden, sodass der Mikro-Chip (2) von dem Trägerkörper (1.1) getrennt wird, **dadurch gekennzeichnet,**
**dass** während des Anlegens der Spitze (5.1) an dem Mikro-Chip (2) ein Ansprengprozess initiiert wird, sodass der vom Trägerkörper (1.1) getrennte Mikro-Chip (2) an der Spitze (5.1) durch Adhäsionskraft gehalten zum Substrat (6) transportiert und dort abgelegt wird.

2. Verfahren zum Abtrennen eines Mikro-Chips (2) aus einem Trägerkörper (1.1) eines Wafers (1) und Aufbringen des Mikro-Chips (2) auf ein Substrat (6) nach Anspruch 1, **dadurch gekennzeichnet,**
**dass** an die Spitze (5.1) eine elektrische Spannung angelegt wird, womit elektrostatische Kräfte erzeugt werden, die den Ansprengprozess unterstützen.

3. Verfahren zum Abtrennen eines Mikro-Chips (2) aus einem Trägerkörper (1.1) eines Wafers (1) und Aufbringen des Mikro-Chips (2) auf ein Substrat (6) nach Anspruch 1 oder 2, **dadurch gekennzeichnet,**
**dass** beim Anlegen des Mikro-Chips (2) auf dem Substrat (6) ein weiterer Ansprengprozess initiiert wird, wobei die bewirkte Adhäsionskraft zwischen dem Substrat (6) und dem Mikro-Chip (2) größer ist als die Adhäsionskraft zwischen der Spitze (5.1) und dem Mikro-Chip (2), sodass nach dem Abheben der Spitze (5.1) von dem Substrat (6) der Mikro-Chip (2) durch Adhäsionskraft an dem Substrat (6) haftet.

4. Verfahren zum Abtrennen eines Mikro-Chips (2) aus einem Trägerkörper (1.1) eines Wafers (1) und Aufbringen des Mikro-Chips (2) auf ein Substrat (6) nach Anspruch 3, **dadurch gekennzeichnet,**
**dass** an das Substrat (6) eine elektrische Spannung angelegt wird, womit elektrostatische Kräfte erzeugt werden, die den Ansprengprozess unterstützen.

5. Verfahren zum Abtrennen eines Mikro-Chips (2) aus einem Trägerkörper (1.1) eines Wafers (1) und Aufbringen des Mikro-Chips (2) auf ein Substrat (6) nach Anspruch 1, **dadurch gekennzeichnet,**
**dass** der Mikro-Chip (2) von seinem Mittelpunkt her beginnend an die Spitze (5.1) relativ angelegt wird.

6. Verfahren zum Abtrennen eines Mikro-Chips (2) aus einem Trägerkörper (1.1) eines Wafers (1) und Aufbringen des Mikro-Chips (2) auf ein Substrat (6) nach Anspruch 3 oder 4, **dadurch gekennzeichnet,**
**dass** eine laserinduzierte Metallabscheidung generiert wird, die an einem Rand des auf dem Substrat (6) haftenden Mikro-Chips (2) eine Metallwulst (7) bildet, womit der Mikro-Chip (2) dauerhaft mit dem Substrat (6) verbunden wird.

7. Vorrichtung zum Abtrennen eines Mikro-Chips (2) aus einem Trägerkörper (1.1) eines Wafers (1), mit einer Unterlage (4), zum Auflegen des Wafers (1) und einem Handlinggerät (5) mit einer Spitze (5.1), die horizontal zum Mikro-Chip (2) positionierbar und vertikal absenkbar und anhebbar ist, **dadurch gekennzeichnet,**
**dass** ein freies Ende (5.1.1) der Spitze (5.1) wenigstens über eine Kontaktfläche, über die sie an dem Mikro-Chip (2) zur Anlage kommt, eine Oberflächenqualität aufweist, die geeignet ist, um zwischen dem Mikro-Chip (2) und der Spitze (5.1) eine Adhäsionskraft zu bewirken, die größer der Gewichtskraft des Mikro-Chips (2) ist, und
**dass** während des Anlegens der Spitze (5.1) an dem Mikro-Chip (2) ein Ansprengprozess initiiert wird, sodass der vom Trägerkörper (1.1) getrennte Mikro-Chip (2) an der Spitze (5.1) durch die Adhäsionskraft gehalten zu einem Substrat (6) transportiert und dort abgelegt wird.

8. Vorrichtung zum Abtrennen eines Mikro-Chips (2) aus einem Trägerkörper (1.1) eines Wafers (1) nach Anspruch 7 , **dadurch gekennzeichnet,**
**dass** das freie Ende (5.1.1) der Spitze (5.1) wenigstens über eine Kontaktfläche kugelförmig ist, sodass sich der Mikro-Chip (2) von seiner Mitte her beginnend gleichmäßig an die Spitze (5.1) anlegt.

9. Vorrichtung zum Abtrennen eines Mikro-Chips (2) aus einem Trägerkörper (1.1) eines Wafers (1) nach Anspruch 8, **dadurch gekennzeichnet,**
**dass** das freie Ende (5.1.1) der Spitze (5.1) als Kugel ausgebildet ist.

10. Vorrichtung zum Abtrennen eines Mikro-Chips (2) aus einem Trägerkörper (1.1) eines Wafers (1) nach Anspruch 7, **dadurch gekennzeichnet,**
**dass** die Vorrichtung ein Koordinatenmessgerät ist mit einer Positioniereinrichtung, die als Handlinggerät (5) dient und einem Messtisch, der als Unterlage (4) dient, wobei an der Positioniereinrichtung ein taktiler Messsensor vorhanden ist, der die Spitze (5.1) enthält.

## Claims

1. Method for severing a microchip (2) from a carrier body (1.1) of a wafer (1) and arranging the microchip (2) on a substrate (6), wherein the microchip (2) is connected to the carrier body (1.1) inside a cutout (1.2) of the carrier body (1.1) by a plurality of retaining tabs (3), comprising the following method steps:
• arranging the wafer (1) on a rigid base (4),
• arranging a tip (5.1) of a handling device (5) above the microchip (2),
• moving the tip (5.1) downward towards the microchip (2), wherein shear forces and/or bending forces act on the retaining tabs (3) while the tip (5.1) contacts the microchip (2) and these retaining tabs (3) are broken so that the microchip (2) is severed from the carrier body (1.1), **characterized in that**
while the tip (5.1) contacts the microchip (2), a contact bonding process is initiated so that the microchip (2) which is severed from the carrier body (1.1) is held at the tip (5.1) by adhesive force, transported to the substrate (6) and deposited on the latter.

2. Method for severing a microchip (2) from a carrier body (1.1) of a wafer (1) and arranging the microchip (2) on a substrate (6) according to claim 1, **characterized in that** voltage is applied to the tip (5.1) so that electrostatic forces reinforcing the contact bonding process are generated.

3. Method for severing a microchip (2) from a carrier body (1.1) of a wafer (1) and arranging the microchip (2) on a substrate (6) according to claim 1 or 2, **characterized in that** a further contact bonding process is initiated when the microchip (2) contacts the substrate (6), wherein the adhesive force which is brought about between the substrate (6) and the microchip (2) is greater than the adhesive force between the tip (5.1) and the microchip (2) so that the microchip (2) adheres to the substrate (6) by adhesive force after the tip (5.1) is lifted from the substrate (6).

4. Method for severing a microchip (2) from a carrier body (1.1) of a wafer (1) and arranging the microchip (2) on a substrate (6) according to claim 3, **characterized in that** voltage is applied to the substrate (6) so that electrostatic forces reinforcing the contact bonding process are generated.

5. Method for severing a microchip (2) from a carrier body (1.1) of a wafer (1) and arranging the microchip (2) on a substrate (6) according to claim 1, **characterized in that** the microchip (2), starting from its centre point, contacts the tip (5.1) relatively.

6. Method for severing a microchip (2) from a carrier body (1.1) of a wafer (1) and arranging the microchip (2) on a substrate (6) according to claim 3 or 4, **characterized in that** a laser-induced metal deposition is generated, which forms a metal bead (7) at an edge of the microchip (2) adhering to the substrate (6) so that the microchip (2) is permanently connected to the substrate (6).

7. Device for severing a microchip (2) from a carrier body (1.1) of a wafer (1) comprising a base (4) for depositing the wafer (1) and a handling device (5) with a tip (5.1) which can be positioned horizontally relative to the microchip (2) and lowered and raised vertically, **characterized in that** a free end (5.1.1) of the tip (5.1) has, at least over a contact surface via which it comes in contact with the microchip (2), a surface quality which is suitable to bring about an adhesive force between the microchip (2) and the tip (5.1) that is greater than the weight force of the microchip (2), and that, while the tip (5.1) contacts the microchip (2), a contact bonding process is initiated so that the microchip (2) which is severed from the carrier body (1.1) is held at the tip (5.1) by the adhesive force, transported to a substrate (6) and deposited on the latter.

8. Device for severing a microchip (2) from a carrier body (1.1) of a wafer (1) according to claim 7, **characterized in that** the free end (5.1.1) of the tip (5.1) is spherical at least over a contact surface so that the microchip (2) contacts the tip (5.1) uniformly starting from the centre of the microchip (2).

9. Device for severing a microchip (2) from a carrier body (1.1) of a wafer (1) according to claim 8, **characterized in that** the free end (5.1.1) of the tip (5.1) is formed as a ball.

10. Device for severing a microchip (2) from a carrier body (1.1) of a wafer (1) according to claim 7, **characterized in that** the device is a coordinate measuring machine with a positioning arrangement which serves as handling device (5) and a measuring table which serves as base (4), wherein a tactile measuring sensor containing the tip (5.1) is provided at the positioning arrangement.

## Revendications

1. Procédé de séparation d'une puce (2) d'un corps de support (1.1) d'une plaquette (1) et application de la puce (2) sur un substrat (6), la puce (2) étant reliée au corps de support (1.1) dans une échancrure (1.2) du corps de support (1.1) par une pluralité de pattes de retenue (3), comprenant les étapes de procédé suivantes:
• placer la plaquette (1) sur une base rigide (4),
• placer une pointe (5.1) d'un dispositif de manutention (5) au-dessus de la puce (2),
• déplacer la pointe (5.1) vers le bas vers la puce (2), lors du contact de la pointe (5.1) avec la puce (2), des forces de cisaillement et / ou de flexion agissant sur les pattes de retenue (3) et lesdites pattes de retenue (3) étant cassées, de sorte que la puce (2) est séparée du corps de support (1.1), **caractérisé en ce que**
lors du contact de la pointe (5.1) avec la puce (2), un processus d'accolage est initié de sorte que la puce (2) séparée du corps de support (1.1) est retenue à la pointe (5.1) par une force d'adhérence, transportée au substrat (6) et déposée sur celui-ci.

2. Procédé de séparation d'une puce (2) d'un corps de support (1.1) d'une plaquette (1) et application de la puce (2) sur un substrat (6) selon la revendication 1, **caractérisé en ce qu'**une tension électrique est appliquée à la pointe (5.1), de sorte que des forces électrostatiques qui supportent le processus d'accolage sont générées.

3. Procédé de séparation d'une puce (2) d'un corps de support (1.1) d'une plaquette (1) et application de la puce (2) sur un substrat (6) selon la revendication 1 ou 2, **caractérisé en ce que**, lors de l'application de la puce (2) sur le substrat (6), un autre processus d'accolage est initié, la force d'adhérence produite entre le substrat (6) et la puce (2) étant supérieure à la force d'adhérence entre la pointe (5.1) et la puce (2), de sorte que la puce (2) adhère au substrat (6) par la force d'adhérence après la pointe (5.1) a été soulevée du substrat (6).

4. Procédé de séparation d'une puce (2) d'un corps de support (1.1) d'une plaquette (1) et application de la puce (2) sur un substrat (6) selon la revendication 3, **caractérisé en ce qu'**une tension électrique est appliquée au substrat (6), de sorte que des forces électrostatiques qui supportent le processus d'accolage sont générées.

5. Procédé de séparation d'une puce (2) d'un corps de support (1.1) d'une plaquette (1) et application de la puce (2) sur un substrat (6) selon la revendication 1, **caractérisé en ce que** la puce (2), commençant à partir de son centre, est relativement appliquée à la pointe (5.1).

6. Procédé de séparation d'une puce (2) d'un corps de support (1.1) d'une plaquette (1) et application de la puce (2) sur un substrat (6) selon la revendication 3 ou 4, **caractérisé en ce qu'**un dépôt métallique induit par laser est généré, qui forme un boudin métallique (7) sur un bord de la puce (2) adhérant au substrat (6), de sorte que la puce (2) est reliée au substrat (6) de manière permanente.

7. Dispositif de séparation d'une puce (2) d'un corps de support (1.1) d'une plaquette (1), comprenant une base (4) pour déposer la plaquette (1) et un dispositif de manutention (5) avec une pointe (5.1) qui peut être positionnée horizontalement par rapport à la puce (2) et abaissée et soulevée verticalement, **caractérisé en ce qu'**une extrémité libre (5.1.1) de la pointe (5.1) a, au moins sur une surface de contact via laquelle elle contacte la puce (2), une qualité de surface qui est adaptée pour provoquer une force d'adhérence entre la puce (2) et la pointe (5.1), qui est supérieure au poids de la puce (2), et que, lors du contact de la pointe (5.1) avec la puce (2), un processus d'accolage est initié de sorte que la puce (2) séparée du corps de support (1.1) est retenue à la pointe (5.1) par une force d'adhérence, transportée au substrat (6) et déposée sur celui-ci.

8. Dispositif de séparation d'une puce (2) d'un corps de support (1.1) d'une plaquette (1) selon la revendication 7, **caractérisé en ce que** l'extrémité libre (5.1.1) de la pointe (5.1) est sphérique au moins sur une surface de contact de sorte que la puce (2) est appliquée à la pointe (5.1), commençant uniformément à partir du centre de la puce (2).

9. Dispositif de séparation d'une puce (2) d'un corps de support (1.1) d'une plaquette (1) selon la revendication 8, **caractérisé en ce que** l'extrémité libre (5.1.1) de la pointe (5.1) est formée en tant que bille.

10. Dispositif de séparation d'une puce (2) d'un corps de support (1.1) d'une plaquette (1) selon la revendication 7, **caractérisé en ce que** le dispositif est une machine de mesure de coordonnées avec un dispositif de positionnement qui sert de dispositif de manutention (5) et une table de mesure qui sert de base (4), un capteur de mesure tactile contenant la pointe (5.1) étant prévu au dispositif de positionnement.
